(19) Europäisches Patentamt
European Patent Office
Office européen des brevets

(11) EP 3 120 458 B1

(12) **FASCICULE DE BREVET EUROPÉEN**

(45) Date de publication et mention
de la délivrance du brevet:
**28.03.2018 Bulletin 2018/13**

(21) Numéro de dépôt: **15709531.6**

(22) Date de dépôt: **17.02.2015**

(51) Int Cl.:
**H03K 5/135** (2006.01)  **G06F 1/08** (2006.01)
**H03L 7/18** (2006.01)

(86) Numéro de dépôt international:
**PCT/FR2015/050377**

(87) Numéro de publication internationale:
**WO 2015/140431 (24.09.2015 Gazette 2015/38)**

(54) **PROCÉDÉ ET CIRCUIT D'AJUSTEMENT DE LA FRÉQUENCE D'UN SIGNAL D'HORLOGE**

VERFAHREN UND SCHALTUNG ZUR ANPASSUNG EINES CLOCKSIGNALS

METHOD AND CIRCUIT FOR ADJUSTING A CLOCK SIGNAL

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **20.03.2014 FR 1452351**

(43) Date de publication de la demande:
**25.01.2017 Bulletin 2017/04**

(73) Titulaire: **WISeKey Semiconductors**
**13590 Meyreuil (FR)**

(72) Inventeurs:
• **MIGAIROU, Vincent**
**F-13530 Trets (FR)**
• **ROCHE, Julien**
**F-13200 Arles (FR)**

(74) Mandataire: **de Roquemaurel, Bruno et al**
**OMNIPAT**
**24 Place des Martyrs de la Résistance**
**13100 Aix en Provence (FR)**

(56) Documents cités:
**EP-A1- 2 549 355  US-A- 5 815 043**
**US-B1- 6 204 694**

**Description**

La présente invention concerne un procédé d'ajustement d'une fréquence d'oscillateur et un circuit d'ajustement de fréquence d'oscillateur. En particulier, l'invention concerne un procédé permettant d'ajuster automatiquement la fréquence d'horloge d'un dispositif USB (Universal Serial Bus) et un dispositif USB comprenant un tel circuit d'ajustement de fréquence d'horloge.

La norme USB est basée sur une spécification technique détaillant des communications entre un contrôleur hôte (tel qu'un ordinateur personnel) et un dispositif, par exemple un clavier, une souris, un appareil photo numérique, une mémoire externe, etc. via une interface appelée port USB. La norme USB 2.0 définit différents débits de transfert de données, y compris un mode bas débit à 1,5 Mb/s avec une marge de précision de $\pm 1,5\%$, et un plein débit à 12 Mb/s avec une marge de précision de $\pm 0,25\%$.

Comme le contrôleur hôte n'envoie pas de signal d'horloge au dispositif, le dispositif doit générer son propre signal d'horloge avec suffisamment de précision pour respecter le débit de transfert de données USB exigé. Un oscillateur à cristaux de quartz peut être prévu, mais cette solution ne convient pas aux applications à faible coût et occupe trop d'espace. Une solution alternative est de baser la génération des cycles d'horloge sur un signal de synchronisation envoyé par l'hôte, par exemple un signal de début de trame ou un signal d'entretien "Keep Alive" envoyé en l'absence de trafic pour empêcher le dispositif d'entrer dans un état de veille. Dans ce cas, l'intervalle de temps entre deux signaux de synchronisation consécutifs est de 1 ms. Pour un dispositif USB fonctionnant à bas débit, avec une fréquence d'horloge de 6 MHz, une marge de précision de $\pm 1,5\%$ donne une marge de fréquence de $\pm 90$ KHz, rendant entre 5910 et 6090 cycles d'horloge par intervalle de temps de 1 ms. Pour un dispositif USB fonctionnant à plein débit, avec une fréquence d'horloge de 48 MHz, une marge de précision de $\pm 0,25\%$ donne une marge de fréquence de $\pm 120$ KHz, rendant entre 47880 et 48120 cycles d'horloge par intervalle de temps de 1 ms.

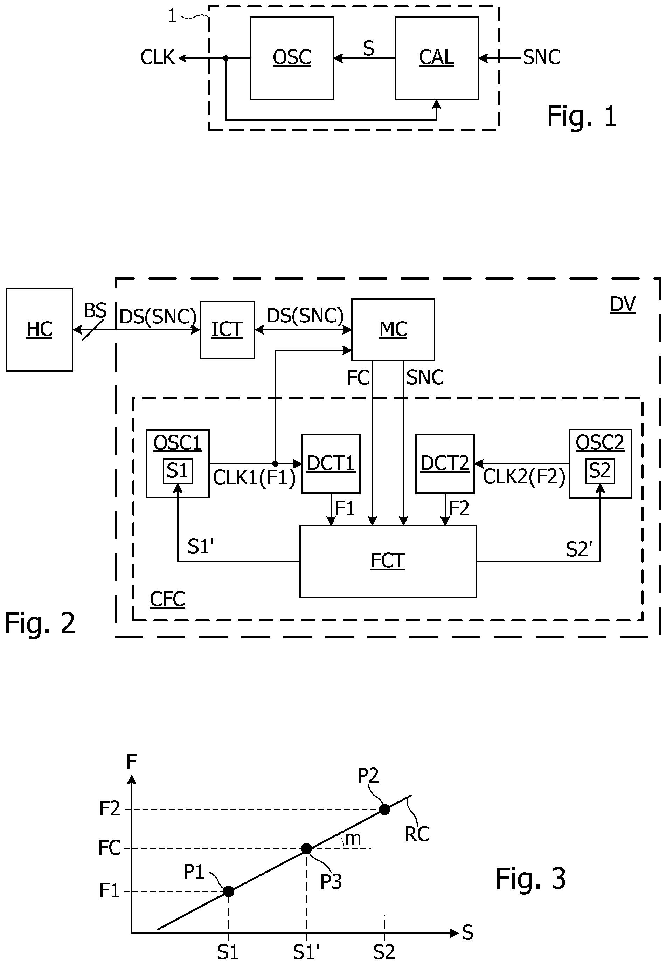

La figure 1 illustre un circuit d'ajustement de fréquence d'horloge 1 comprenant un oscillateur OSC et une unité d'étalonnage CAL. L'oscillateur OSC génère un signal d'horloge CLK qui est fourni à l'unité d'étalonnage CAL. Lorsque l'unité d'étalonnage CAL reçoit une première occurrence d'un signal de synchronisation SNC, elle commence à compter le nombre de cycles du signal d'horloge CLK sur son entrée jusqu'à la prochaine occurrence du signal de synchronisation, où elle s'arrête de compter. L'unité d'étalonnage CAL détermine la différence entre le nombre compté de cycles et le nombre souhaité de cycles, puis fournit un signal de contrôle S à l'oscillateur OSC, qui augmente ou diminue sa fréquence en conséquence.

Il s'avère que le saut de fréquence en sortie de l'oscillateur OSC résultant de l'application du signal de contrôle S, est inconnu. En effet, le fonctionnement de l'oscillateur peut varier avec le temps, par exemple en raison d'une variation de température ou de de tension d'alimentation, altérant le fonctionnement de l'oscillateur. Ainsi, la fréquence obtenue en sortie de l'oscillateur pourra être trop élevée ou trop basse après la première phase d'ajustement.

Le nombre de cycles d'horloge est par conséquent recompté lors du prochain intervalle de temps afin de déterminer le pas de fréquence de l'oscillateur. L'unité d'étalonnage CAL fournit à nouveau le signal de contrôle S à l'oscillateur OSC pour obtenir la fréquence souhaitée après le second intervalle de temps.

La demande FR 2 978 258 (US 2013/0021106) décrit un circuit d'ajustement de fréquence d'horloge comprenant deux oscillateurs identiques générant un signal d'horloge dont la fréquence est ajustable par des lignes à retard en fonction d'une valeur de commande, et un circuit configuré pour mesurer la fréquence de chacun des deux oscillateurs, et déterminer de nouvelles valeurs de commande à partir des mesures de fréquence et des valeurs de commande précédentes, et d'une valeur de fréquence souhaitée. La précision de ce circuit pour ajuster la fréquence dépend de l'identité du comportement des deux oscillateurs. On peut constater qu'en augmentant leur fréquence, les oscillateurs présentent des comportements qui divergent. Ainsi, ce circuit offre une précision qui peut s'avérer insuffisante pour certains protocoles de transmission. Une telle divergence est également mise en exergue avec les récentes technologies de fabrication permettant de miniaturiser davantage les circuits intégrés. En particulier, lorsque la dimension critique (ou la plus petite largeur de grille de transistors) du circuit intégré est inférieure à 100 nm, il est difficile de limiter à des valeurs acceptables les divergences de caractéristiques des oscillateurs, même si ces derniers se trouvent dans un même circuit intégré.

Il s'avère également que plus on augmente la fréquence des oscillateurs, plus les variations de conditions de fabrication des circuits, les variations de température ambiante et de tension d'alimentation induisent des variations de fréquence importantes, et donc plus le nombre de cycles nécessaires pour atteindre la fréquence souhaitée augmente.

Il en résulte que dans de nombreuses applications, notamment de transmission de données, cette solution ne permet pas d'atteindre la fréquence souhaitée suffisamment rapidement ou avec une précision suffisante. En particulier, cette solution ne convient pas à un dispositif USB fonctionnant à pleine vitesse, soit avec un signal d'horloge à 48 MHz.

Il est donc souhaitable de proposer un circuit d'horloge susceptible d'être totalement intégré, c'est-à-dire ne nécessitant pas de composants tels qu'un cristal de quartz. Il est également souhaitable que ce circuit d'horloge puisse atteindre rapidement une fréquence souhaitée, même si cette fréquence est élevée, et si le circuit d'horloge est réalisé conformément aux dernières technologies de fabrication de circuits intégrés. Il est également souhaitable que la fréquence souhaitée soit atteinte avec une précision suffisante.

Des modes de réalisation concernent un procédé d'ajustement d'une fréquence d'horloge d'oscillateur, comprenant les étapes consistant à : appliquer une première valeur de commande à un premier oscillateur, appliquer une seconde valeur de commande distincte de la première valeur de commande, à un second oscillateur, mesurer une fréquence de chacun des premier et second oscillateurs, déterminer par interpolation une nouvelle première valeur de commande en fonction des fréquences mesurées, des première et seconde valeurs de commande, et d'une fréquence souhaitée, et appliquer la nouvelle première valeur de commande au premier oscillateur. Selon un mode de réalisation, le procédé comprend une étape de détermination par interpolation d'une mesure de fréquence corrigée du second oscillateur, en fonction d'un écart de fréquence mesuré entre les premier et second oscillateurs soumis à une même troisième valeur de commande, de la troisième valeur de commande, et de la valeur de commande appliquée au second oscillateur, la mesure de fréquence corrigée étant utilisée en tant que mesure de fréquence du second oscillateur pour déterminer la nouvelle première valeur de commande.

Selon un mode de réalisation, le procédé comporte une phase de calibration comprenant des étapes consistant à : appliquer la troisième valeur de commande à chacun des deux oscillateurs, et mesurer l'écart de fréquence entre les fréquences des deux oscillateurs soumis à la troisième valeur de commande.

Selon un mode de réalisation, le procédé comporte une phase de calibration comprenant des étapes consistant à : appliquer une valeur de commande minimum à chacun des deux oscillateurs, mesurer un premier écart de fréquence entre les fréquences des deux oscillateurs soumis à la valeur de commande minimum, appliquer une valeur de commande maximum à chacun des deux oscillateurs, mesurer un second écart de fréquence entre les fréquences des deux oscillateurs soumis à la valeur de commande maximum, déterminer un écart de pente entre des courbes de réponse des premier et second oscillateurs en fonction d'une différence entre les premier et second écarts et d'une différence entre les valeurs de commande minimum et maximum, l'écart de pente étant utilisé pour déterminer par interpolation la mesure de fréquence corrigée.

Selon un mode de réalisation, la mesure de fréquence corrigée est déterminée en fonction d'un écart de fréquence mesuré entre les premier et second oscillateurs soumis à une valeur de commande minimum, et de la valeur de commande minimum.

Selon un mode de réalisation, la troisième valeur de commande est telle que la fréquence mesurée du premier oscillateur soumis à la troisième valeur de commande, correspond à la fréquence souhaitée.

Selon un mode de réalisation, le procédé comporte une phase de calibration comprenant des étapes consistant à : déterminer la troisième valeur de commande, et mesurer la fréquence du second oscillateur soumis à la troisième valeur de commande.

Selon un mode de réalisation, chaque mesure de fréquence de l'un ou l'autre des deux oscillateurs comprend une étape de comptage d'un nombre de cycles de l'oscillateur durant une période d'un signal de synchronisation.

Selon un mode de réalisation, le signal de synchronisation est fourni par une interface de communication.

Selon un mode de réalisation, le procédé comporte une étape de fourniture d'un signal à la fréquence du premier oscillateur, en sortie du premier oscillateur, en tant que signal d'horloge d'un dispositif conforme à la norme USB 2.0, la fréquence du premier oscillateur étant égale à 6 MHz avec une marge d'erreur de $\pm$ 90 KHz, ou à 48 MHz avec une marge d'erreur de $\pm$ 120 KHz.

Selon un mode de réalisation, la détermination de la nouvelle première valeur de commande comprend des étapes consistant à : déterminer une première différence entre les fréquences mesurées des premier et second oscillateurs, déterminer une seconde différence entre la fréquence souhaitée et la fréquence mesurée de l'un des premier et second oscillateurs, diviser la première différence par une différence de valeurs de commande appliquées aux premier et second oscillateurs, pour obtenir un pas de fréquence, diviser la seconde différence par le pas de fréquence pour obtenir une valeur de correction, et ajouter la valeur de correction à la première valeur de commande pour obtenir la nouvelle valeur de commande.

Selon un mode de réalisation, la différence de valeurs de commande est fixée, une nouvelle seconde valeur de commande est déterminée en fonction de la nouvelle première valeur de commande ou de la valeur de correction pour conserver la différence de valeurs de commande.

Des modes de réalisation concernent également un circuit d'ajustement de fréquence d'un oscillateur à une fréquence souhaitée, comprenant des premier et second oscillateurs ayant chacun une fréquence ajustable par une valeur de commande, le circuit d'ajustement de fréquence étant configuré pour mettre en oeuvre le procédé défini précédemment.

Selon un mode de réalisation, chacun des premier et second oscillateurs comprend un oscillateur en anneau comportant des circuits à retard activables séparément en fonction de la valeur de commande appliquée à l'oscillateur.

Des modes de réalisation concernent également un dispositif USB 2.0 comprenant : un circuit d'interface recevant un signal de données conforme à la norme USB 2.0, et le circuit d'ajustement de fréquence défini précédemment.

Selon un mode de réalisation, le circuit d'interface fournit le signal de synchronisation au circuit d'ajustement de fréquence.

Des exemples de réalisation seront décrits dans ce qui suit, à titre non limitatif en relation avec les figures jointes parmi lesquelles :

la figure 1 précédemment décrite illustre un circuit d'ajustement de fréquence d'horloge conventionnel,
la figure 2 représente sous forme de blocs un dispositif comprenant un circuit d'ajustement de fréquence d'horloge d'oscillateur, selon un mode de réalisation,
la figure 3 est un graphique indiquant la relation entre les valeurs de fréquence et de commande de l'oscillateur pour le circuit d'ajustement de fréquence de la figure 2,
la figure 4 est un schéma de principe d'un oscillateur présent dans le circuit d'ajustement de fréquence de la figure 2,
la figure 5 est un schéma de principe du circuit d'ajustement de fréquence de la figure 2, selon un mode de réalisation,
les figures 6 à 8 sont des graphiques indiquant des courbes de variation des fréquences des deux oscillateurs du circuit d'ajustement de fréquence de la figure 2, en fonction d'une valeur de commande,
la figure 9 représente un schéma de principe du circuit d'ajustement de fréquence de la figure 2, selon un autre mode de réalisation,
les figure 10 et 11 représentent sous la forme de blocs un circuit de correction présent dans le circuit de la figure 9, selon deux modes de réalisation distincts,
la figure 12 représente une séquence d'étapes exécutées durant une phase de calibration du circuit d'ajustement de fréquence de la figure 9.

La figure 2 représente un dispositif DV comprenant une interface de communication ICT, un microcontrôleur MC, et un circuit d'ajustement de fréquence d'horloge CFC selon un mode de réalisation. Le dispositif DV est relié à un contrôleur hôte HC via le circuit d'interface ICT au moyen d'un bus BS. Le microcontrôleur MC est relié au circuit d'interface ICT et au circuit CFC au moyen de fils de connexion.

Le circuit CFC comprend deux oscillateurs OSC1, OSC2, deux circuits de mesure de fréquence DCT1, DCT2, et un circuit de calcul FCT pour déterminer des commandes d'ajustement de fréquence à appliquer aux oscillateurs. Les oscillateurs OSC1, OSC2 reçoivent chacun du circuit FCT une valeur de commande S1, S2, respectivement. La valeur de commande S1, S2 correspond à un ajustement de fréquence (retard ou avance) qui peut être appliqué à l'oscillateur pour ajuster sa fréquence, à la hausse ou à la baisse.

Un signal de données DS est transmis entre le contrôleur hôte HC et le dispositif DV au moyen du bus BS. Un signal de synchronisation SNC, tel qu'un signal d'entretien ou un signal de début de trame selon la norme USB 2.0, est inclus dans le signal de données et transféré au microcontrôleur MC via le circuit d'interface ICT. Le microcontrôleur MC transfère ensuite le signal SNC au circuit CFC.

Le signal de synchronisation SNC définit des périodes ou des intervalles de temps, un intervalle de temps représentant le temps entre deux occurrences ou impulsions consécutives du signal SNC. Le microcontrôleur MC fournit également, au circuit de calcul FCT, une valeur de fréquence souhaitée FC correspondant à la fréquence de signal d'horloge requise pour ses besoins en termes de transfert de données, par exemple 6 MHz ou 48 MHz.

Lors d'un premier intervalle de temps, l'oscillateur OSC1 fonctionne avec une valeur de commande S1, et génère un signal d'horloge CLK1 présentant une fréquence F1. Le signal d'horloge CLK1(F1) est fourni au microcontrôleur MC pour ses besoins et au circuit de mesure DCT1. Le circuit de mesure DCT1 mesure la fréquence du signal d'horloge en entrée et fournit en sortie la mesure de fréquence F1 au circuit FCT. De même, l'oscillateur OSC2 fonctionne avec une valeur de commande S2, et génère un signal d'horloge CLK2 présentant une fréquence F2. Le signal d'horloge CLK2(F2) est fourni au circuit de mesure DCT2. Le circuit de mesure DCT2 mesure la fréquence du signal d'horloge en entrée et fournit en sortie la mesure de fréquence F2 au circuit FCT.

Le circuit de calcul FCT calcule ensuite une nouvelle valeur de commande S1' à partir des valeurs de fréquence F1, F2, des valeurs de commande S1, S2, et de la valeur de fréquence souhaitée FC. La nouvelle valeur de commande S1' est appliquée à l'oscillateur OSC1 lors d'un intervalle de temps suivant afin d'obtenir la fréquence souhaitée FC en sortie de l'oscillateur OSC1. De manière optionnelle, une nouvelle valeur de commande S2' peut être déterminée et appliquée à l'oscillateur OSC2 de façon similaire.

La figure 3 est un graphique illustrant la relation entre les valeurs de fréquence F et les valeurs de commande S des oscillateurs OSC1, OSC2 à un certain intervalle de temps. Un point P1 correspond à la fréquence F1 de l'oscillateur OSC1 et à sa valeur de commande S1. Un point P2 correspond à la fréquence F2 de l'oscillateur OSC2 et à sa valeur de commande S2. Une courbe de réponse RC est extrapolée à partir des points P1, P2. Un point P3 sur la courbe RC correspond à la fréquence souhaitée FC de l'oscillateur OSC1 et à la nouvelle valeur de commande S1' à appliquer à l'oscillateur OSC1 lors de l'intervalle de temps suivant afin d'obtenir la fréquence souhaitée FC. La forme ou la pente de la courbe RC et sa position par rapport aux axes des commandes et des fréquences varient d'un circuit à un autre et en fonction de la température ambiante et de la tension d'alimentation du circuit. En revanche, comme les deux oscillateurs sont réalisés dans un même circuit, cette courbe est la même pour les deux oscillateurs et varie de la même manière en fonction de la température ambiante et de la tension d'alimentation du circuit. Dans l'exemple de la figure 3, les fréquences F1, F2 et les valeurs de commande S1, S2 sont respectivement supérieures et inférieures à la fréquence souhaitée FC et à la valeur de commande S1'. Il sera compris que dans d'autres cas, les fréquences F1, F2 et les valeurs de commande S1, S2 peuvent toutes être supérieures ou inférieures à la fréquence FC et à la valeur de commande S1'.

Par conséquent, la valeur de commande S1' peut être déterminée à l'aide des valeurs F1, S1, F2, S2, FC en exploitant les relations entre les points P1, P2, P3. Par exemple, en supposant que la courbe de réponse RC est une droite, il est bien connu que pour trouver la pente p d'une droite définie par deux points p1(x1, y1) et p2(x2, y2), il est possible d'utiliser l'équation générale suivante :

$$p = (y1 - y2) / (x1 - x2) \qquad (1)$$

dans laquelle p est la pente et (x1, y1) et (x2, y2) sont respectivement les coordonnées des deux points P1, P2.

Le circuit d'ajustement de fréquence d'horloge CFC, et plus particulièrement le circuit de calcul FCT illustré sur la figure 2, calcule la nouvelle valeur de commande de fréquence S1' afin d'obtenir la fréquence souhaitée FC en mettant en oeuvre les équations illustrées ci-après. Spécifiquement, la nouvelle valeur de commande S1' peut être calculée grâce aux équations suivantes et aux valeurs de fréquence F1, F2 des oscillateurs OSC1, OSC2, aux valeurs de commande S1, S2, et à la valeur de fréquence souhaitée FC.

La pente p de la courbe de réponse RC passant par les points P1, P2, P3 est égale à :

$$p = (FC - F1) / (S1' - S1) \qquad (2)$$
$$= (F1 - F2) / (S1 - S2) \qquad (3)$$

L'équation (2) permet de déduire la nouvelle valeur de commande S1' :

$$S1' = S1 + (FC - F1) / p \qquad (4)$$

Le terme (F1-FC) / p est une "correction" CR1 qui est ajoutée à S1. Cette correction CR1 peut être une valeur négative ou positive, selon les positions respectives des points P1, P2 par rapport au point P3. Si la fréquence F1 de l'oscillateur est supérieure à la fréquence souhaitée, la valeur de commande S1 de l'oscillateur OSC1 est diminuée au lieu d'être augmentée afin d'obtenir la nouvelle valeur de commande S1'.

Puisque F1, F2, S1, S2 sont des valeurs connues, la pente p de la courbe de réponse RC peut être directement calculée à l'aide de l'équation (3) comme suit :

$$p = (F1 - F2) / (S1 - S2) \qquad (5)$$

Par conséquent, la nouvelle valeur de commande S1' peut être calculée en remplaçant l'équation (5) dans l'équation (4) comme suit :

$$S1' = S1 + (FC - F1) / [(F1 - F2) / (S1 - S2)] \qquad (6)$$

soit

$$S1' = S1 + \Delta Fx / \Delta Fr / \Delta S \qquad (7)$$

Il en résulte que la correction CR1 peut être obtenue par l'équation suivante :

$$CR1 = \Delta Fx / \Delta Fr / \Delta S \qquad (8)$$

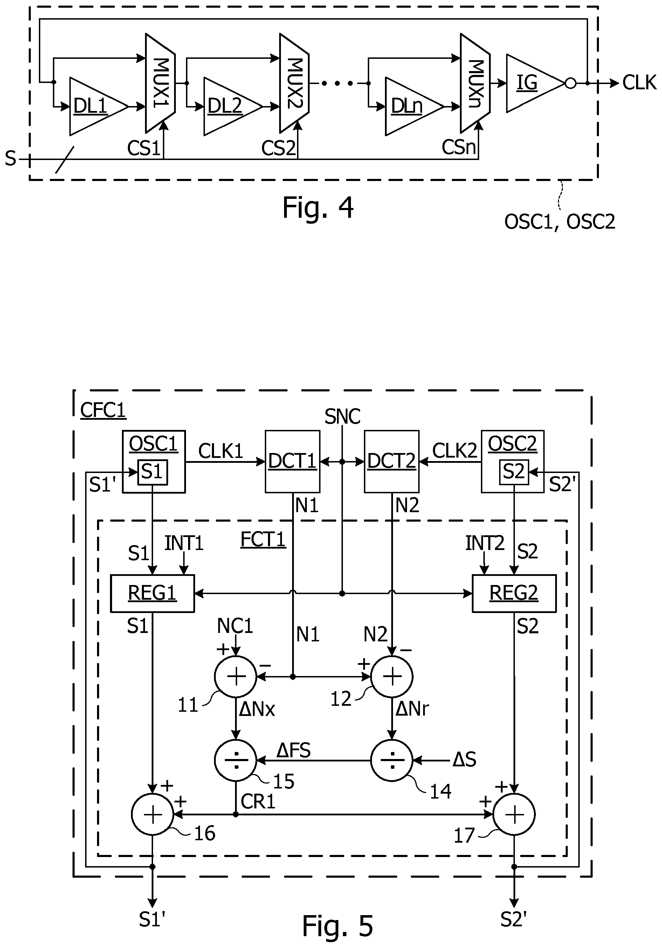

La figure 4 est un schéma de principe d'un oscillateur du type oscillateur en anneau. Selon un mode de réalisation, chaque oscillateur OSC1, OSC2 comprend un tel oscillateur. L'oscillateur OSC1, OSC2 comprend une porte inverseuse IG, n circuits à retard DL1 à DLn, et n circuits multiplexeurs MUX1 à MUXn, pour un total n de groupes de circuit à retard et multiplexeur DL - MUX. Le nombre maximum n de groupes de circuit à retard - multiplexeur peut aller de quelques groupes à plusieurs centaines, selon le degré de précision requis, l'espace disponible pour l'oscillateur, etc. Ainsi, dans un exemple de réalisation, l'oscillateur OSC1, OSC2 comprend 512 groupes de circuit à retard et multiplexeur DL - MUX.

Chaque multiplexeur MUX1- MUXn présente une entrée connectée à une sortie du circuit à retard DL1-DLn correspondant, et une entrée connectée à une liaison qui contourne le circuit à retard correspondant. Chaque multiplexeur est contrôlé par la valeur de commande S, par exemple un signal de contrôle CS0, CS1, ... CSn obtenu à partir d'un décodage (non représenté sur la figure 4) de la valeur de commande S. L'entrée de la porte inverseuse IG est connectée à la sortie du dernier multiplexeur MUXn et la sortie de la porte IG fournit le signal d'horloge CLK, qui est également fourni au premier circuit à retard DL1 et au premier multiplexeur MUX1.

A titre d'exemple, pour un oscillateur comprenant un total de n = 32 groupes de circuit à retard - multiplexeur DL - MUX, une valeur de commande S=10 conduira dix des multiplexeurs MUX1-MUXn à sélectionner l'entrée contournant le circuit à retard correspondant, les autres multiplexeurs sélectionnant l'entrée connectée au circuit à retard correspondant. Il en résulte que la fréquence maximum en sortie de l'oscillateur est diminuée de dix fois le retard d'un des circuits à retard DL1-DLn. S'il est ultérieurement nécessaire de diminuer la fréquence de l'oscillateur, la valeur de commande S peut être abaissée, par exemple à S = 8 afin de sélectionner deux des circuits à retard DL1-DLn, diminuant la fréquence en sortie de deux fois la valeur du retard. Ainsi, la valeur de commande S détermine le nombre de multiplexeurs MUX1-MUXn sélectionnant leur entrée non retardée.

Il doit être compris que plus la valeur de commande S de l'oscillateur OSC1, OSC2 est élevée, plus le nombre de multiplexeurs MUX pour sélectionner les entrées non retardées est élevé, moins le retard est important, et ainsi plus la fréquence d'horloge est élevée. Un pas de fréquence ΔFS est défini comme le résultat en sortie de l'oscillateur de la différence de nombre de cycles d'horloge N en raison d'un ajustement de la valeur de commande S d'un seul pas (en sélectionnant ou désélectionnant un seul circuit à retard DL de l'oscillateur). Le pas de fréquence ΔFS correspond donc au retard introduit par un circuit à retard DL.

Lors d'une phase de conception des oscillateurs OSC1, OSC2, le retard de chaque circuit à retard est calculé, et le nombre de cellules à retard est choisi de telle sorte que la fréquence cible peut être atteinte dans toutes les conditions de travail : meilleur scénario, scénario typique et pire scénario. Le nombre de circuits retard DL1-DLn qui peuvent être activés par les signaux de commande CS1-CSn parmi les n de groupes de circuit de retard - multiplexeur disponibles pour un oscillateur, est compris entre un nombre minimum correspondant à une valeur de commande maximum SM et un nombre maximum correspondant à une valeur de commande minimum Sm. En général, la valeur Sm est égale à zéro et la valeur SM est égale au nombre total n de groupes circuit à retard - multiplexeur. Cependant, en fonction de la conception et la fabrication de l'oscillateur, ces valeurs peuvent différer. Par exemple, il peut être déterminé que pour que l'oscillateur soit capable d'atteindre la fréquence cible FC, au moins cinq circuits à retard DL ne doivent jamais être activés. Dans ce cas, Sm peut être choisi égal à 5.

De préférence, la sélection des circuits à retard DL conduit à une variation linéaire de la fréquence en sortie de l'oscillateur. De plus, les oscillateurs OSC1, OSC2 sont de préférence conçus pour être aussi identiques que possible, pour obtenir la meilleure précision possible dans le calcul de chacune des nouvelles valeurs de commande S.

La figure 5 est un schéma de principe d'un circuit d'ajustement de fréquence d'horloge CFC1 selon un mode de réalisation. Le circuit CFC1 comprend les oscillateurs OSC1, OSC2, les circuits de mesure de fréquence DCT1, DCT2, et un circuit de calcul de valeur de commande FCT1.

Lors d'un premier intervalle de temps, l'oscillateur OSC1 fonctionne avec une valeur de commande S1, et génère un signal d'horloge CLK1 présentant une valeur de fréquence F1. Le signal d'horloge CLK1(F1) est fourni au microcontrôleur MC (non représenté) pour ses besoins et au circuit DCT1. Le circuit de mesure DCT1 peut comprendre par exemple un compteur recevant en entrée le signal de synchronisation SNC et le signal d'horloge CLK1. Lors de la réception d'une première occurrence (par exemple un front montant ou descendant) du signal de synchronisation SNC, le circuit DCT1 commence à compter le nombre de cycles d'horloge du signal d'horloge CLK1 sur son entrée. A de la réception d'une seconde occurrence du signal de synchronisation SNC, le circuit DCT1 arrête de compter le nombre de cycles d'horloge et fournit en sortie au circuit de calcul FCT1 une valeur de décompte de cycles d'horloge N1 du signal CLK1.

De la même façon, l'oscillateur OSC2 fonctionne avec une valeur de commande S2, et génère un signal d'horloge CLK2 présentant une valeur de fréquence F2. Le signal d'horloge CLK2(F2) est fourni au circuit DCT2, qui reçoit également en entrée le signal de synchronisation SNC et compte le nombre de cycles d'horloge du signal d'horloge CLK2 entre deux occurrences du signal de synchronisation SNC. Le circuit de mesure DCT2 fournit en sortie au circuit de calcul FCT1 une valeur de décompte de cycles d'horloge N2 du signal CLK2.

Le circuit de calcul FCT1 comprend deux registres REG1, REG2, deux sommateurs 11, 12, deux diviseurs 14, 15, et deux sommateurs 16, 17. Les registres REG1, REG2 reçoivent chacun en entrée la valeur de commande actuelle de l'oscillateur OSC1, OSC2 correspondant (ici les valeurs de commandes S1, S2), le signal de synchronisation SNC, et des valeurs initiales INT1, INT2 fournies par le microcontrôleur MC par exemple.

Initialement, pour la première utilisation du dispositif, les registres REG1, REG2 sont chargés avec des valeurs de commande respectives initiales INT1, INT2 déterminées par exemple par le microcontrôleur MC, et l'oscillateur OSC1, OSC2 est également réglé sur cette valeur de commande. Puis, sur réception d'une occurrence du signal de synchronisation SNC, le registre REG1, REG2 est chargé avec la valeur de commande actuelle S1, S2 de l'oscillateur OSC1, OSC2 correspondant, et fournit en sortie la valeur S1, S2 au sommateur 16, 17. Ainsi, l'oscillateur OSC1 peut initialement recevoir du microcontrôleur MC en tant que valeur initiale INT1, la valeur de commande SC1 correspondant à la valeur de décompte souhaitée NC1, telles que déterminées durant une phase de calibration et mémorisées par le microcontrôleur MC. L'oscillateur OSC2 peut initialement recevoir du microcontrôleur MC en tant que valeur initiale INT2, la valeur de commande SC1 -ΔS, la différence ΔS étant un paramètre de fonctionnement MC mémorisé par le microcontrôleur et défini lors d'une phase de paramétrage du circuit de calcul FCT1, FCT2.

Le sommateur 11 reçoit sur une entrée directe la valeur de décompte souhaitée NC1, par exemple fournie par le microcontrôleur MC, et sur une entrée inverseuse, la valeur de décompte mesurée N1, fournie par le circuit DCT1. Le sommateur 11 calcule la différence ΔNx (= NC1-N1) entre la valeur de décompte souhaité NC1 et la valeur de décompte mesurée N1, et fournit en sortie la différence ΔNx au sommateur 12. Le sommateur 12 reçoit sur une entrée directe la valeur de décompte mesurée N1 fournie par le circuit DCT1, et sur une entrée inverseuse la valeur de décompte mesurée N2, fournie par le circuit DCT2. Le sommateur 12 calcule la différence ΔNr (= N1 - N2) représentant la différence entre les valeurs de décompte mesurées N1, N2 des oscillateurs OSC1, OSC2.

Le diviseur 14 reçoit sur une première entrée la différence ΔNr calculée par le sommateur 12, et sur une seconde entrée, la différence ΔS (= S1-S2) entre les valeurs de commande S1, S2 des oscillateurs OSC1, OSC2. La différence ΔS peut être une valeur fixée, mémorisée et fournie par le microcontrôleur MC. Le diviseur 14 effectue une division de la première entrée par la seconde entrée ΔNr/ΔS, afin de trouver la pente p, en accord avec l'équation (5) ci-dessus. La pente p correspond au pas de fréquence ΔFS des deux oscillateurs OSC1, OSC2, pour un pas de valeur de commande S des oscillateurs.

Le diviseur 15 reçoit du sommateur 11 sur une première entrée la différence ΔNx (correspondant à la différence de fréquence ΔFx), et sur une seconde entrée le pas de fréquence ΔFS fourni par le diviseur 14. Le diviseur 15 effectue une division de la première entrée par la seconde entrée ΔNx / ΔFS, afin de trouver la correction CR1 selon l'équation (8) ci-dessus.

Le sommateur 16 reçoit sur une entrée la correction CR1 du diviseur 15, et sur une autre entrée la valeur de commande S1 mémorisée dans le registre REG1. Le sommateur 16 ajoute la correction CR1 à la valeur de commande S1, en accord avec l'équation (7). Ainsi, si la valeur du décompte N1 est supérieure à la valeur souhaitée NC1, la différence ΔNx est négative. La correction CR1 est donc également négative. Il en résulte que la valeur de commande S1' est inférieure à la valeur de commande S1, ce qui conduit à augmenter le retard de l'oscillateur OSC1. Inversement, si la valeur du décompte N1 est inférieure à la valeur souhaitée NC1, la correction CR1 est positive, et la valeur de commande S1' est supérieure à la valeur de commande S1, ce qui conduit à diminuer le retard de l'oscillateur OSC1. Le sommateur 16 fournit la nouvelle valeur de commande S1' à l'oscillateur OSC1, qui ajuste sa fréquence en conséquence afin d'obtenir le décompte souhaité NC1. La nouvelle valeur de commande S1' est également chargée dans le registre REG1, en remplaçant la valeur de commande précédente S1.

De même, le sommateur 17 reçoit sur une entrée la correction CR1 fournie par le diviseur 15, et sur une autre entrée la valeur de commande S2 mémorisée dans le registre REG2. Le sommateur 17 ajoute la correction CR1 à la valeur de commande S2, puis fournit la nouvelle valeur de commande S2' à l'oscillateur OSC2, qui ajuste sa fréquence en conséquence. La nouvelle valeur de commande S2' est également chargée dans le registre REG2, en remplaçant la valeur de commande précédente S2.

Au lieu de calculer la nouvelle valeur de commande S2' de l'oscillateur OSC2 à partir de la valeur commande courante S2, la valeur S2' peut être obtenue en ajoutant la différence ΔS à la nouvelle valeur de commande S1' de l'oscillateur OSC1.

Il peut être envisagé de calculer la différence ΔS entre les valeurs de commande S1, S2 à chaque calcul de nouvelles valeurs de commande S1', S2'. Dans ce cas, il est préférable, mais non nécessaire de modifier la valeur de commande S2 de l'oscillateur OSC2 chaque fois que la valeur de commande S1 de l'oscillateur OSC1 est modifiée, afin de maintenir constante la différence entre les valeurs de commande S1, S2. Il est également préférable d'éviter que les valeurs de commande S1, S2 soient égales, pour qu'une correction CR1 puisse toujours être calculée. En effet, si la différence de valeurs de commande ΔS est nulle, le diviseur 14 serait amené à effectuer une division par 0.

Dans un mode de réalisation, la différence ΔS entre S1 et S2 est fixée à une puissance de 2. Cela simplifie la division par le diviseur 14 pour trouver le pas de fréquence ΔFS, puisque diviser un nombre par deux revient à un déplacement d'un bit vers la droite du résultat, le bit le plus faible étant soit négligé soit déplacé en position décimale. Ce mode de réalisation permet d'utiliser un diviseur à faible coût. Par exemple, ΔS= S1 - S2 est fixé à $2^x$. Ainsi, après l'application d'une correction CR1 à l'oscillateur OSC1, l'oscillateur OSC2 peut également être ajusté pour maintenir une différence d'une puissance de deux $2^x$ avec l'oscillateur OSC1.

Il est à noter que le choix d'une grande valeur pour la différence ΔS permet d'obtenir une meilleure précision, à condition que la courbe de réponse CR des oscillateurs OSC1, OSC2 soit une droite. Dans le cas contraire, la différence ΔS peut être choisie de telle sorte que la courbe de réponse entre deux valeurs espacées de la différence ΔS puisse être assimilée à une droite.

Exemples numériques

A titre de premier exemple, il est supposé que lors d'un intervalle de temps, N1 = 6500, S1 = 24, N2 = 5500, S2 = 16 (la différence ΔS est fixée à 8), et NC1 = 6000. Le circuit de calcul FCT1 calcule ΔNx= -500 et ΔNr = 1000. Le pas de fréquence ΔFS vaut 1000/8 = 125, et la correction CR1 est évaluée à -500/125 = -4. La nouvelle valeur de commande S1' est donc égale à 24 + (-4) = 20 pour augmenter le retard de l'oscillateur OSC1 et obtenir le décompte souhaité de NC1 = 6000, qui correspond à la fréquence FC de 6 MHz. Le retard de l'oscillateur OSC2 peut être augmenté de la même correction grâce à une valeur de commande S2' = 12, afin de maintenir la différence de fréquence ΔS(= S1 - S2) entre les deux oscillateurs OSC1, OSC2.

Lors de l'intervalle de temps suivant, N1 = 6000, S1 = 20, N2 = 5000, S2 = 12, et NC1 = 6000. Comme la différence ΔNx entre le décompte N1 de l'oscillateur OSC1 et le décompte souhaité NC1 de l'oscillateur OSC1 est égale à 0, la fréquence de l'oscillateur OSC1 ne nécessite pas d'être ajustée. La fréquence souhaitée FC est donc atteinte après un seul intervalle de temps.

Si pour un intervalle de temps ultérieur, les fréquences des oscillateurs OSC1, OSC2 commencent à dériver, par exemple en raison d'une augmentation de température, la différence entre le décompte mesuré N1 de l'oscillateur OSC1 et le décompte souhaité NC1 n'est plus égale à zéro, et l'ajustement de fréquence peut être effectué à nouveau. Ainsi, par exemple, N1 = 5750, S1 = 20, N2 = 4750, S2 = 12, et NC1 = 6000. Le circuit de calcul FCT1 calcule ΔNx = 400 et ΔNr= 1000. Le pas de fréquence ΔFS= 1000/8 = 125, et la correction CR1 = 250/125 = 2. La nouvelle valeur de commande S1' est égale à 20 + 2 = 22 pour diminuer le retard de l'oscillateur OSC1. Le retard de l'oscillateur OSC2 peut être diminué de la même correction pour obtenir une valeur de commande S2' = 14.

Il sera également compris qu'un nombre non entier peut être calculé pour la valeur de commande S1'. Dans ce cas, la valeur de commande S1' appliquée à l'oscillateur OSC1 peut être arrondie au nombre entier suivant ou précédent, puisqu'il n'est pas possible d'ajouter ou de soustraire une fraction d'un circuit à retard DL. Le décompte réel en sortie de l'oscillateur ne sera pas exactement égal au décompte souhaité, mais sera très certainement dans la plage de précision acceptable de l'oscillateur.

A titre d'exemple afin d'illustrer ce dernier point, il est supposé que N1 = 6300, S1 = 26, N2 = 5400, S2 = 18, ΔS = 8 et NC1 = 6000. Le circuit de calcul FCT1 calcule ΔNx= -300 et ΔNr= 900. Le pas de fréquence ΔFS vaut 900/8 = 112,5 et la correction CR1 est égale à -300/112,5 = 2,6, qui est arrondie à 3. La nouvelle valeur de commande S1' est réglée à 23 pour diminuer la fréquence de l'oscillateur OSC1 afin d'obtenir un décompte d'environ 6006, qui est dans la plage de précision (± 1,5%) comprise entre 5910 et 6090 de la fréquence souhaitée, tel qu'exigé par la norme USB 2.0.

Dans certaines conditions, il peut être difficile de réaliser deux oscillateurs ayant des caractéristiques de fonctionnement suffisamment proches, notamment des pentes p suffisamment proches, de sorte que les valeurs de commande S1 et S2 ne peuvent pas être calculées avec suffisamment de précision pour atteindre la fréquence souhaitée suffisamment rapidement. Cette difficulté à réaliser deux oscillateurs identiques apparaît notamment avec des oscillateurs ayant une fréquence élevée (notamment supérieure à 30 MHz), et dans les circuits intégrés à haute densité de composants, obtenus par les dernières technologies de fabrication présentant une dimension critique inférieure à 100 nm.

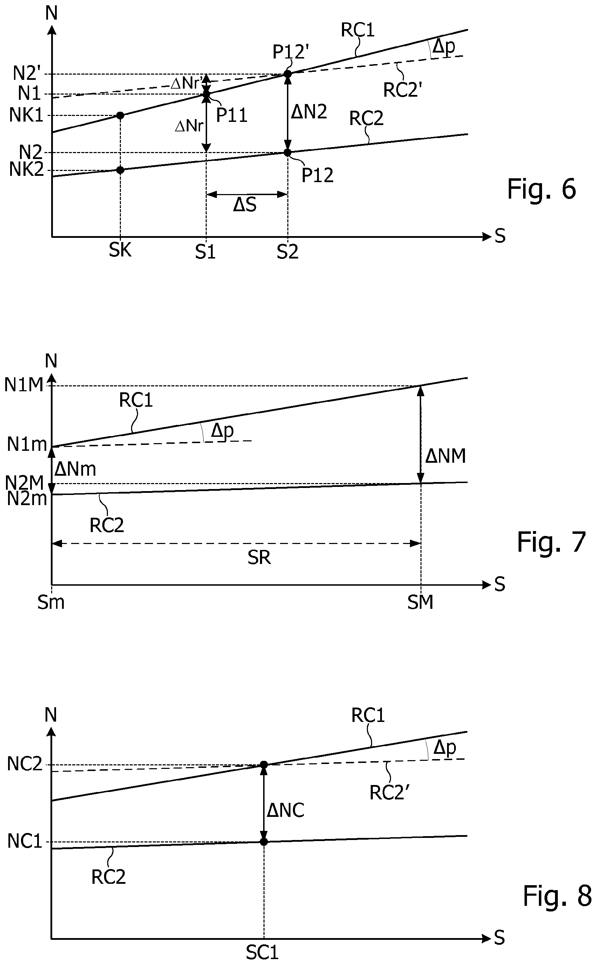

La figure 6 est un graphique illustrant un cas où les deux oscillateurs présentent des courbes de réponse RC1, RC2 différentes de la fréquence de sortie F (ou de décompte N) en fonction de la valeur de commande S. La pente ou la forme de ces courbes de réponse sont variables d'un circuit à un autre et varient en fonction de la température ambiante et de la tension d'alimentation du circuit. En revanche, comme les deux oscillateurs sont formés dans le même circuit intégré, l'écart entre les deux courbes reste sensiblement constant, et donc ne varie pas de façon significative en fonction de la température ambiante ou de la tension d'alimentation du circuit. Si les deux oscillateurs n'ont pas la même courbe de réponse en fréquence F ou décompte N, en fonction de la valeur de commande S, l'écart mesuré ΔNr égal à N1 - N2, est différent de l'écart ΔNr'= N1 - N2' qui devrait être pris en compte pour le calcul effectué par le circuit FCT1 de la figure 5, c'est-à-dire en supposant que les deux oscillateurs OSC1, OSC2 présentent la même courbe de réponse RC1. Pour évaluer l'écart réel ΔNr' ou la valeur de décompte N2', il convient de considérer le point P11 de la courbe RC1 présentant les coordonnées (S1, N1), le point P12 de la courbe RC2 et présentant les coordonnées (S2, N2) et le point P12' de la courbe RC1 ayant les coordonnées (S2, N2'). La figure 6 représente également une courbe RC2' parallèle à la courbe RC2 et passant par le point P12'. La différence de pentes entre les courbes entre les courbes RC1 et RC2 correspond donc à la différence de pentes Δp entre les courbes RC1 et RC2'. Par une approximation linéaire (en supposant que les courbes de réponse sont des droites), la différence de pentes Δp entre les courbes RC1 et RC2 peut être exprimée de la manière suivante :

$$\Delta p = [(N2' - N2) - (NK1 - NK2)] / (S2 - SK) \qquad (9)$$

NK1 et NK2 étant des valeurs de décompte connues, mesurées en sortie des oscillateurs OSC1, OSC2 recevant une même valeur de commande SK également connue. Il en résulte qu'un décompte corrigé N2C peut être évalué de la manière suivante :

$$N2C = N2' = N2 + (NK1 - NK2) + \Delta p \cdot (S2 - SK) \qquad (10)$$

dans laquelle la quantité CR2 = (NK1 - NK2) + $\Delta p \cdot$(S2- SK) représente une correction à ajouter au décompte mesuré N2 pour obtenir la valeur de décompte corrigée N2C.

Pour déterminer la différence de pente $\Delta p$, considérons la figure 7 représentant les courbes de réponse RC1, RC2. La différence de pente $\Delta p$ peut être évaluée en mesurant les écarts entre les deux courbes RC12, RC2 à leur extrémités, c'est-à-dire en appliquant aux oscillateurs OSC1, OSC2 les valeurs extrêmes Sm, SM de la valeur de commande S, et en mesurant les décomptes N1m, N2m, N1M, N2M à ces valeurs extrêmes. La différence de pente $\Delta p$ peut être obtenue par une équation analogue à l'équation (9), comme suit :

$$\Delta p = [(N1M - N2M) - (N1m - N2m)] / (SM - Sm) \qquad (11)$$

soit, en posant $\Delta$NM=(N1M- N2M), $\Delta$Nm= (N1m - N2m), et SR = SM - Sm :

$$\Delta p = (\Delta NM - \Delta Nm) / SR \qquad (12)$$

SR représente l'étendue des valeurs de commande des oscillateurs OSC1, OSC2.

Les unes ou les autres des valeurs de décompte aux valeurs extrêmes Sm, SM peuvent être utilisées comme valeurs connues dans l'équation (10). Ainsi la valeur de décompte corrigée N2C peut être obtenue à l'aide de l'équation suivante :

$$N2C = N2 + \Delta Nm + \Delta p \cdot (S2 - Sm) \qquad (13)$$

Soit, si Sm est égal à 0 :

$$N2C = N2 + \Delta Nm + \Delta p \cdot S2 \qquad (14)$$

Selon un autre mode de réalisation, on utilise comme valeur connue de décompte relative à l'oscillateur OSC1, la valeur de décompte NC1 qui correspond à la fréquence souhaitée FC, et qui est obtenue avec une valeur de commande SC1 déterminée durant une phase de calibration du circuit CFC. La figure 8 représente les courbes RC1, RC2, RC2', la valeur de décompte souhaitée NC1 sur la courbe RC1, et les valeurs correspondantes de commande SC1 et de décompte issue de l'oscillateur OSC2 pour cette même valeur de commande SC1. Ainsi, la valeur de décompte corrigée N2C peut être obtenue à l'aide de l'équation suivante :

$$N2C = N2 + \Delta NC + \Delta p \cdot (S2 - SC1) \qquad (15)$$

avec $\Delta$NC = NC1 - NC2 et $\Delta p$= ($\Delta$NM- $\Delta$Nm)/ SR.

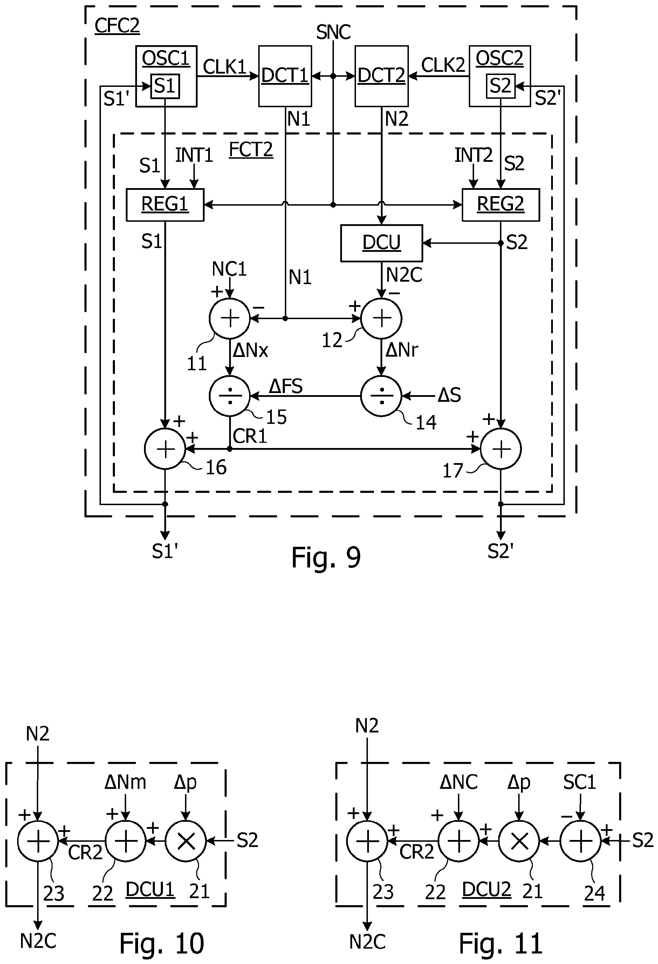

La figure 9 est un schéma de principe d'un circuit d'ajustement de fréquence d'horloge CFC2 selon un autre mode de réalisation. Le circuit CFC2 comprend comme le circuit CFC1, les oscillateurs OSC1, OSC2, les circuits de mesure de fréquence DCT1, DCT2, et un circuit de calcul de valeur de commande FCT2 remplaçant dans ce mode de réalisation le circuit FCT1. Le circuit de calcul FCT2 diffère du circuit de calcul FCT1 en ce qu'il comprend un circuit de correction de décompte DCU disposé en entrée du sommateur 12 (entre le compteur DCT2 et le sommateur 12). Le circuit DCU est configuré pour mettre en oeuvre l'équation (10), ou plus précisément l'équation (13), (14) ou (15), afin de déterminer la valeur corrigée N2C qui est fournie en entrée du sommateur 12 en remplacement de la valeur de décompte N2.

La figure 10 est un schéma de principe d'un circuit de correction DCU, selon un mode de réalisation. Le circuit DCU1 représenté sur la figure 10 met en oeuvre l'équation (14). Le circuit DCU1 comprend un multiplieur 21 et deux sommateurs 22, 23. Le multiplieur 21 reçoit la valeur de commande S2 du registre REG2, et la différence de pente $\Delta p$ du microcontrôleur MC. Le multiplieur 21 fournit à une entrée du sommateur 22, la quantité $\Delta p \cdot S2$. Le sommateur 22 reçoit par ailleurs du microcontrôleur l'écart de décomptes $\Delta Nm$ des oscillateurs OSC1, OSC2 à la valeur de commande minimum Sm. Le sommateur 22 fournit à une entrée du sommateur 23 la valeur de correction CR2 ($=\Delta Nm + \Delta p \cdot S2$). Le sommateur 23 reçoit par ailleurs la valeur de décompte N2 à corriger et fournit en sortie du circuit DCU1 la valeur de décompte corrigée N2C ($= N2 + \Delta Nm + \Delta p \cdot S2$).

La figure 11 est un schéma de principe d'un circuit de correction DCU, selon un autre mode de réalisation. Le circuit DCU2 représenté sur la figure 11 met en oeuvre l'équation (15). Le circuit DCU2 diffère du circuit DCU1 en ce qu'il comprend un sommateur supplémentaire 24 interposé entre l'entrée de la valeur de commande S2 et l'entrée du sommateur 21. Ainsi, le sommateur 21 comprend une entrée directe recevant la valeur de commande S2 du registre REG2 et une entrée inverseuse recevant la valeur de commande SC1 correspondant à la valeur de décompte souhaitée NC1 pour l'oscillateur OSC1, fournie par le microcontrôleur MC. Le sommateur 24 fournit donc en entrée du multiplieur 21, la quantité S2-SC1. Par ailleurs, au lieu de recevoir l'écart $\Delta Nm$, le sommateur 22 reçoit l'écart $\Delta NC$ ($= N1C - N2C$) conformément à l'équation (15).

Le circuit CFC2 permet ainsi de générer un signal d'horloge (CLK1) précisément synchronisé, dès l'obtention des décomptes N1, N2, c'est-à-dire dès la réception par le circuit d'une seconde occurrence du signal de synchronisation SNC.

En définitive, le microcontrôleur MC mémorise et fournit au circuit de calcul FCT2, les valeurs suivantes: NC1, SC1, $\Delta S$, $\Delta p$, et $\Delta Nm$ ou $\Delta NC$. L'écart de valeurs de commandes $\Delta S$ est un paramètre de fonctionnement à définir et à introduire dans le microcontrôleur MC. Les autres valeurs peuvent être déterminées durant un traitement de calibration des oscillateurs OSC1, OSC2, par exemple effectuées par le microcontrôleur MC. Le traitement de calibration peut être effectué une seule fois, par exemple en fin de chaine de fabrication du circuit, en le soumettant à une température ambiante moyenne (située par exemple entre 20 et 25°C).

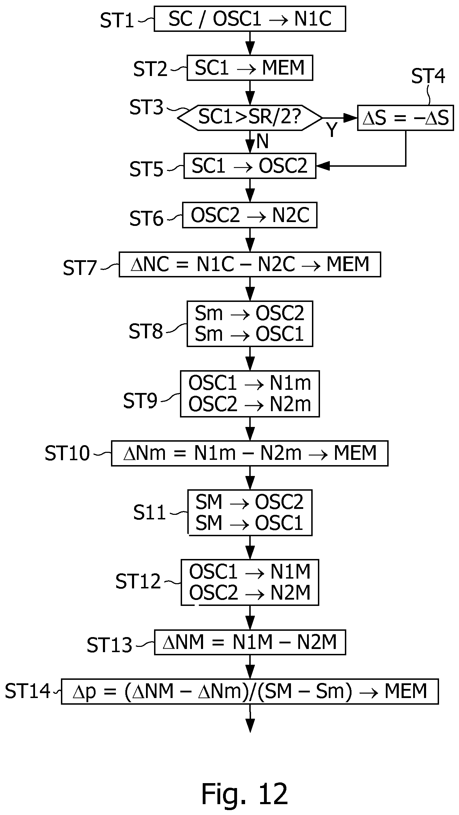

Des étapes ST1 à ST14 d'un traitement de calibration, selon un mode de réalisation, sont représentées sur la figure 12. A l'étape ST1, des valeurs de commande S1 sont appliquées successivement à l'oscillateur OSC1, et à chaque valeur de commande, la valeur de décompte N1 est mesurée sur le signal de sortie de l'oscillateur OSC1, jusqu'à ce que cette valeur de décompte soit égale à la valeur de décompte souhaitée N1C. Pour que l'oscillateur OSC1 atteigne la valeur N1C, le microcontrôleur MC peut sélectionner les valeurs de commande S1 par dichotomie, en partant d'une valeur médiane ($= SR / 2$) de la plage de valeurs de commande SR. A l'étape ST2, la valeur de commande SC1 trouvée à l'étape ST1 est mémorisée. A l'étape ST3, la valeur de commande SC1 peut être comparée avec la valeur médiane SR/2 de la plage de valeurs de commande SR. Si la valeur SC1 est supérieure à la valeur médiane SR / 2, l'étape ST4 est exécutée avant les étapes ST5 à ST14, sinon seules les étapes ST5 à ST14 sont exécutées. A l'étape ST4, le signe de l'écart $\Delta S$ mémorisé par le microcontrôleur MC est inversé. Les étapes ST3 et ST4 sont prévues optionnellement pour permettre de disposer pour l'oscillateur OSC2 d'une plage de réglage la plus large possible entre les valeurs Sm et SM, compte tenu du fait que les valeurs de commande S1, S2 appliquées aux oscillateurs OSC1, OSC2 diffèrent de la valeur d'écart $\Delta S$. A l'étape ST5, la valeur de commande SC1 est appliquée à l'oscillateur OSC2. A l'étape ST6, la valeur de décompte NC2 est mesurée sur le signal de sortie de l'oscillateur OSC2. A l'étape ST7, l'écart $\Delta NC$ entre les valeurs de commande N1C et N2C peut être optionnellement calculé et mémorisé pour la mise en oeuvre de l'équation (15).

Les étapes ST8 à ST14 visent à calculer l'écart de pente $\Delta p$. A l'étape ST8, la valeur minimum de commande est appliquée aux oscillateurs OSC1 et OSC2. A l'étape ST9, les valeurs de décompte correspondantes N1m, N2m sont mesurées sur les signaux de sortie des oscillateurs OSC1, OSC2 commandés par le signal Sm. A l'étape ST10, l'écart $\Delta Nm$ est calculé à partir des valeurs de décompte mesurées N1m, N2m, et cet écart est mémorisé. A l'étape ST11, la valeur maximum de commande SM est appliquée aux oscillateurs OSC1 et OSC2. A l'étape ST12, les valeurs de décompte correspondantes N1M, N2M sont mesurées sur les signaux de sortie des oscillateurs OSC1, OSC2 commandés par le signal SM. A l'étape ST13, l'écart $\Delta NM$ est calculé à partir des valeurs de décompte mesurées N1M, N2M. A l'étape ST14, la différence de pente $\Delta p$ est calculée à partir des écarts $\Delta NM$, $\Delta Nm$, et de l'écart SR entre les valeurs de commande SM et Sm en appliquant l'équation (12), et la valeur d'écart de pente obtenue est mémorisée.

Il est clair pour l'homme de l'art que divers autres modes de réalisation peuvent être prévus. En particulier, des modes de réalisations alternatifs d'un oscillateur peuvent être prévus. Par exemple, au lieu d'un oscillateur en anneau comprenant n circuits à retard et seulement un inverseur, chaque oscillateur peut comprendre une pluralité d'inverseurs qui sont sélectionnés ou désélectionnés en conséquence. Par ailleurs pour bénéficier d'un pas de fréquence $\Delta FS$ plus fin, les oscillateurs peuvent être réalisés à partir de sources de courant activables à la demande pour augmenter la fréquence de l'oscillateur.

De plus, il sera compris par l'homme de l'art que les oscillateurs OSC1, OSC2 ne sont pas nécessairement des oscillateurs en anneau, mais peuvent être n'importe quel type d'oscillateur dont la fréquence peut être ajustée par pas de fréquence réguliers, et que les circuits de mesure de fréquence DCT1, DCT2 peuvent être n'importe quel moyen permettant de déterminer la fréquence d'un oscillateur autrement qu'en comptant un nombre de cycles d'horloge entre deux instances d'un signal de synchronisation. Les registres REG1, REG2 ne font pas nécessairement partie de l'unité de calcul FCT1, FCT2, et peuvent se situer à l'extérieur de ce circuit. La nouvelle valeur de commande de fréquence S1' peut être calculée par rapport à la seconde valeur de commande S2, mais pour une précision optimale, il est préférable de calculer la valeur de commande S1' par rapport à la valeur de commande S1.

Il est également clair pour l'homme de l'art que l'invention couvre également un dispositif n'effectuant pas de phase de calibration, les valeurs déterminées durant cette phase ayant simplement été enregistrées dans le dispositif durant une phase de test en fin de chaine de fabrication.

Le procédé d'ajustement de la fréquence de l'oscillateur peut également inclure une étape de comparaison de la valeur de décompte N1 avec une première et/ou une seconde valeur seuil, par exemple 5910 et 6090 ou 47880 et 48120 dans les exemples décrits ci-dessus. Le procédé d'ajustement peut être effectué seulement si la valeur de décompte N1 est inférieure ou supérieure aux valeurs seuil qui définissent donc entre elles une plage de valeurs acceptables.

De plus, il sera compris dans la description qui précède, que l'application d'interpolations ou d'extrapolations linéaires a été fournie à titre d'exemple uniquement. Des interpolations ou extrapolations non linéaires peuvent bien entendu être utilisées, comme des interpolations ou extrapolations polynomiales.

Egalement, les valeurs de fréquence souhaitées de 6 MHz et 48 MHz ont été données à titre d'exemple uniquement. Toute autre valeur de fréquence souhaitée peut donc être utilisée. Enfin, les termes "fréquence" F et "décompte" N peuvent généralement être échangés dans les équations et les dessins.

Par ailleurs, il peut être prévu des modes de réalisation dans lesquels la détermination de la fréquence du deuxième oscillateur est effectuée dans un intervalle de temps autre que celui dans lequel la fréquence du premier oscillateur est déterminée, par exemple deux intervalles de temps consécutifs définis par le signal de synchronisation SNC.

## Revendications

1. Procédé d'ajustement d'une fréquence d'horloge d'oscillateur, comprenant les étapes consistant à :

   appliquer une première valeur de commande (S1) à un premier oscillateur (OSC1),
   appliquer une seconde valeur de commande (S2) distincte de la première valeur de commande, à un second oscillateur (OSC2),
   mesurer une fréquence (F1, F2 ; N1, N2) de chacun des premier et second oscillateurs,
   déterminer par interpolation une nouvelle première valeur de commande (S1') en fonction des fréquences mesurées, des première et seconde valeurs de commande, et d'une fréquence souhaitée (FC, NC1), et
   appliquer la nouvelle première valeur de commande au premier oscillateur,
   **caractérisé en ce qu'**il comprend une étape de détermination par interpolation d'une mesure de fréquence corrigée (N2C) du second oscillateur (OSC2), en fonction d'un écart de fréquence ($\Delta Nm$, $\Delta NC$) mesuré entre les premier et second oscillateurs soumis à une même troisième valeur de commande (SK, Sm, SC1), de la troisième valeur de commande, et de la valeur de commande (S2) appliquée au second oscillateur, la mesure de fréquence corrigée étant utilisée en tant que mesure de fréquence du second oscillateur pour déterminer la nouvelle première valeur de commande.

2. Procédé selon la revendication 1, comportant une phase de calibration comprenant des étapes consistant à :

   appliquer la troisième valeur de commande (Sm, SC1) à chacun des deux oscillateurs (OSC1, OSC2), et
   mesurer l'écart de fréquence ($\Delta Nm$, $\Delta NC$) entre les fréquences des deux oscillateurs soumis à la troisième valeur de commande.

3. Procédé selon la revendication 1 ou 2, comportant une phase de calibration comprenant des étapes consistant à :

   appliquer une valeur de commande minimum (Sm) à chacun des deux oscillateurs,
   mesurer un premier écart de fréquence ($\Delta Nm$) entre les fréquences des deux oscillateurs soumis à la valeur de commande minimum,
   appliquer une valeur de commande maximum (SM, SC1) à chacun des deux oscillateurs,
   mesurer un second écart de fréquence ($\Delta NM$) entre les fréquences des deux oscillateurs soumis à la valeur de commande maximum,

déterminer un écart de pente (Δp) entre des courbes de réponse des premier et second oscillateurs (OSC1, OSC2) en fonction d'une différence (SR) entre les premier et second écarts et d'une différence entre les valeurs de commande minimum et maximum, l'écart de pente étant utilisé pour déterminer par interpolation la mesure de fréquence corrigée (N2C).

4. Procédé selon l'une des revendications 1 à 3, dans lequel la mesure de fréquence corrigée (N2C) est déterminée en fonction d'un écart de fréquence (ΔNm) mesuré entre les premier et second oscillateurs (OSC1, OSC2) soumis à une valeur de commande minimum (Sm), et de la valeur de commande minimum.

5. Procédé selon l'une des revendications 1 à 3, dans lequel la troisième valeur de commande (SC1) est telle que la fréquence mesurée du premier oscillateur (OSC1) soumis à la troisième valeur de commande, correspond à la fréquence souhaitée (NC1).

6. Procédé selon la revendication 5, comportant une phase de calibration comprenant des étapes consistant à :

déterminer la troisième valeur de commande (SC1), et
mesurer la fréquence (NC2) du second oscillateur (OSC2) soumis à la troisième valeur de commande.

7. Procédé selon l'une des revendications 1 à 6, dans lequel chaque mesure de fréquence de l'un ou l'autre des deux oscillateurs (OSC1, OSC2) comprend une étape de comptage d'un nombre de cycles (N1, N2) de l'oscillateur durant une période d'un signal de synchronisation (SNC).

8. Procédé selon la revendication 7, dans lequel le signal de synchronisation (SNC) est fourni par une interface de communication (ICT).

9. Procédé selon la revendication 8, comprenant une étape de fourniture d'un signal à la fréquence du premier oscillateur (OSC1), en sortie du premier oscillateur, en tant que signal d'horloge d'un dispositif (DV) conforme à la norme USB 2.0, la fréquence (F1) du premier oscillateur étant égale à 6 MHz avec une marge d'erreur de ± 90 KHz, ou à 48 MHz avec une marge d'erreur de ± 120 KHz.

10. Procédé selon l'une des revendications 1 à 9, dans lequel la détermination de la nouvelle première valeur de commande (S1') comprend des étapes consistant à :

déterminer une première différence (ΔNr) entre les fréquences mesurées (N1, N2) des premier et second oscillateurs (OSC1, OSC2),
déterminer une seconde différence (ΔNx) entre la fréquence souhaitée (NC) et la fréquence mesurée (N1) de l'un des premier et second oscillateurs (OSC1, OSC2),
diviser la première différence par une différence (ΔS) de valeurs de commande (S1, S2) appliquées aux premier et second oscillateurs, pour obtenir un pas de fréquence (ΔFS),
diviser la seconde différence par le pas de fréquence pour obtenir une valeur de correction (CR1), et
ajouter la valeur de correction à la première valeur de commande (S1) pour obtenir la nouvelle valeur de commande.

11. Procédé selon la revendication 10, dans lequel la différence de valeurs de commande (ΔS) est fixée, une nouvelle seconde valeur de commande (S2') est déterminée en fonction de la nouvelle première valeur de commande (S1') ou de la valeur de correction (CR1) pour conserver la différence de valeurs de commande.

12. Circuit d'ajustement de fréquence d'un oscillateur à une fréquence souhaitée, comprenant des premier et second oscillateurs (OSC1, OSC2) ayant chacun une fréquence (F1, F2) ajustable par une valeur de commande (S1, S2), le circuit d'ajustement de fréquence étant configuré pour mettre en oeuvre le procédé selon l'une des revendications 1 à 11.

13. Circuit selon la revendication 12, dans lequel chacun des premier et second oscillateurs (OSC1, OSC2) comprend un oscillateur en anneau (OSC) comportant des circuits à retard (DL1-DLn) activables séparément en fonction de la valeur de commande (S1, S2) appliquée à l'oscillateur.

14. Dispositif USB 2.0 comprenant :

un circuit d'interface (ICT) recevant un signal de données (DS) conforme à la norme USB 2.0, et
un circuit d'ajustement de fréquence (CFC, CFC2) selon l'une des revendications 12 et 13.

**15.** Dispositif selon la revendication 14, dans lequel le circuit d'interface (ICT) fournit le signal de synchronisation (SNC) au circuit d'ajustement de fréquence (CFC, CFC2).

**Patentansprüche**

**1.** Verfahren zum Anpassen einer Oszillatortaktfrequenz, die folgenden Schritte umfassend:

Anwenden eines ersten Steuerungswerts (S1) auf einen ersten Oszillator (OSC1),
Anwenden eines zweiten Steuerungswerts (S2), der sich vom ersten Steuerungswert unterscheidet, auf einen zweiten Oszillator (OSC2),
Messen einer Frequenz (F1; F2; N1; N2) eines jeden des ersten und zweiten Oszillators, Bestimmen, durch Interpolieren, eines neuen ersten Steuerungswerts (S1') in Abhängigkeit von den gemessenen Frequenzen, dem ersten und zweiten Steuerungswert und einer gewünschten Frequenz (FC, NC1), und
Anwenden des neuen ersten Steuerungswerts auf den ersten Oszillator,
**dadurch gekennzeichnet, dass** es einen Schritt zum Bestimmen, durch Interpolieren, eines korrigierten Frequenzmesswerts (NC2) des zweiten Oszillators (OSC2) in Abhängigkeit von einer gemessenen Frequenzabweichung ($\Delta$Nm, $\Delta$NC) zwischen dem ersten und dem zweiten Oszillator umfasst, die einem selben dritten Steuerungswert (SK, Sm, SC1) unterworfen sind, dem dritten Steuerungswert und dem Steuerungswert (S2), der auf den zweiten Oszillator angewendet wird, wobei der korrigierte Frequenzmesswert als Frequenzmesswert als Frequenzmesswert des zweiten Oszillators verwendet wird, um den neuen ersten Steuerungswert zu bestimmen.

**2.** Verfahren nach Anspruch 1, eine Kalibrierungsphase umfassend, die die folgenden Schritte umfasst:

Anwenden des dritten Steuerungswerts (Sm, SC1) auf jeden der zwei Oszillatoren (OSC1, OSC2), und
Messen der Frequenzabweichung ($\Delta$Nm, $\Delta$NC) zwischen den Frequenzen der zwei Oszillatoren, die dem dritten Steuerungswert unterworfen sind.

**3.** Verfahren nach Anspruch 1 oder 2, eine Kalibrierungsphase umfassend, die die folgenden Schritte umfasst:

Anwenden eines minimalen Steuerungswerts (Sm) auf jeden der zwei Oszillatoren,
Messen einer ersten Frequenzabweichung ($\Delta$Nm) zwischen den Frequenzen der zwei Oszillatoren, die dem minimalen Steuerungswert unterworfen sind,
Anwenden eines maximalen Steuerungswerts (SM, SC1) auf jeden der zwei Oszillatoren,
Messen einer zweiten Frequenzabweichung ($\Delta$NM) zwischen den Frequenzen der zwei Oszillatoren, die dem maximalen Steuerungswert unterworfen sind,
Bestimmen einer Neigungsabweichung ($\Delta$p) zwischen den Kennlinien des ersten und zweiten Oszillators (OSC1, OSC2) in Abhängigkeit von einer Differenz (SR) zwischen der ersten und zweiten Abweichung und einer Differenz zwischen dem minimalen und maximalen Steuerungswert, wobei die Neigungsabweichung zum Bestimmen, durch Interpolieren, des korrigierten Frequenzmesswerts (N2C) verwendet wird.

**4.** Verfahren nach einem der Ansprüche 1 bis 3, wobei der korrigierte Frequenzmesswert (N2C) in Abhängigkeit von einer Frequenzabweichung ($\Delta$Nm), die zwischen dem ersten und zweiten Oszillator (OSC1, OSC2) gemessen wird, die einem minimalen Steuerungswert (Sm) unterworfen sind, und von dem minimalen Steuerungswert bestimmt wird.

**5.** Verfahren nach einem der Ansprüche 1 bis 3, wobei der dritte Steuerungswert (SC1) dergestalt ist, dass die gemessene Frequenz des ersten Oszillators (OSC1), der dem dritten Steuerungswert unterworfen ist, der gewünschten Frequenz (NC1) entspricht.

**6.** Verfahren nach Anspruch 5, eine Kalibrierungsphase umfassend, die die folgenden Schritte umfasst:

Bestimmen des dritten Steuerungswerts (SC1), und
Messen der Frequenz (NC2) des zweiten Oszillators (OSC2), der dem dritten Steuerungswert unterworfen ist.

**7.** Verfahren nach einem der Ansprüche 1 bis 6, wobei jede Frequenzmessung des einen oder des anderen der zwei Oszillatoren (OSC1, OSC2) einen Schritt des Zählens einer Anzahl von Zyklen (N1, N2) des Oszillators während eines Zeitraums eines Synchronisationssignals (SNC) umfasst.

**8.** Verfahren nach Anspruch 7, wobei das Synchronisationssignal (SNC) durch eine Kommunikationsschnittstelle (ICT) bereitgestellt wird.

**9.** Verfahren nach Anspruch 8, einen Schritt zum Bereitstellen eines Signals mit der Frequenz des ersten Oszillators (OSC1) am Ausgang des ersten Oszillators umfassend, als Taktsignal einer Vorrichtung (DV) gemäß der Norm USB 2.0, wobei die Frequenz (F1) des ersten Oszillators gleich 6 MHz mit einer Fehlerspanne von $\pm$ 90 KHz, oder gleich 48 MHz mit einer Fehlerspanne von $\pm$ 120 KHz ist.

**10.** Verfahren nach einem der Ansprüche 1 bis 9, wobei das Bestimmen des neuen ersten Steuerungswerts (S1') die folgenden Schritte umfasst:

Bestimmen einer ersten Differenz ($\Delta$Nr) zwischen den gemessenen Frequenzen (N1, N2) des ersten und zweiten Oszillators (OSC1, OSC2),
Bestimmen einer zweiten Differenz ($\Delta$Nx) zwischen der gewünschten Frequenz (NC) und der gemessenen Frequenz (N1) des einen des ersten und zweiten Oszillators (OSC1, OSC2),
Teilen der ersten Differenz durch eine Differenz ($\Delta$S) von Steuerungswerten (S1, S2), die auf den ersten und zweiten Oszillator angewendet werden, um einen Frequenzschritt ($\Delta$FS) zu erhalten,
Teilen der zweiten Differenz durch den Frequenzschritt, um einen Korrekturwert (CR1) zu erhalten, und
Hinzufügen des Korrekturwerts zum ersten Steuerungswert (S1), um den neuen Steuerungswert zu erhalten.

**11.** Verfahren nach Anspruch 10, wobei die Differenz von Steuerungswerten ($\Delta$S) fixiert wird, ein neuer zweiter Steuerungswert (S2') in Abhängigkeit von dem neuen ersten Steuerungswert (S1') oder dem Korrekturwert (CR1) bestimmt wird, um die Differenz von Steuerungswerten zu behalten.

**12.** Schaltung zum Anpassen einer Frequenz eines Oszillators an eine gewünschte Frequenz, einen ersten und zweiten Oszillator (OSC1, OSC2) umfassend, die jeder eine durch einen Steuerungswert (S1, S2) anpassbare Frequenz (F1, F2) aufweisen, wobei die Schaltung zum Anpassen einer Frequenz konfiguriert ist, um das Verfahren nach einem der Ansprüche 1 bis 11 umzusetzen.

**13.** Schaltung nach Anspruch 12, wobei jeder des ersten und zweiten Oszillators (OSC1, OSC2) einen Ringoszillator (OSC) umfasst, der Verzögerungsschaltungen (DL1-DLn) umfasst, die getrennt in Abhängigkeit von dem Steuerungswert (S1, S2) aktiviert werden können, der auf den Oszillator angewendet wird.

**14.** USB 2.0 Vorrichtung, umfassend:

eine Schnittstellenschaltung (ICT), die ein Datensignal (DS) gemäß der Norm USB 2.0 empfängt, und
eine Schaltung zum Anpassen einer Frequenz (CFC, CFC2) nach einem der Ansprüche 12 und 13.

**15.** Vorrichtung nach Anspruch 14, wobei die Schnittstellenschaltung (ICT) der Schaltung zum Anpassen einer Frequenz (CFC, CFC2) das Synchronisationssignal (SNC) bereitstellt.

**Claims**

**1.** A method for adjusting an oscillator clock frequency, comprising the steps of:

applying a first control value (S1) to a first oscillator (OSC1),
applying a second control value (S2) different from the first control value, to a second oscillator (OSC2),
measuring a frequency (F1, F2; N1, N2) of each of the first and second oscillators,
determining by interpolation a new first control value (S1') depending on the frequencies measured, on the first and second control values, and on a desired frequency (FC, NC1), and
applying the new first control value to the first oscillator,
**characterized in that** it comprises a step of determining by interpolation a corrected frequency measurement (N2C) of the second oscillator (OSC2), depending on a frequency deviation ($\Delta$Nm, $\Delta$NC) measured between

the first and second oscillators subjected to the same third control value (SK, Sm, SC1), on the third control value, and on the control value (S2) applied to the second oscillator, the corrected frequency measurement being used as frequency measurement of the second oscillator for determining the new first control value.

2. The method according to claim 1, comprising a calibration phase comprising steps of:

applying the third control value (Sm, SC1) to each of the two oscillators (OSC1, OSC2), and
measuring the frequency deviation ($\Delta$Nm, $\Delta$NC) between the frequencies of the two oscillators subjected to the third control value.

3. The method according to claim 1 or 2, comprising a calibration phase comprising steps of:

applying a minimum control value (Sm) to each of the two oscillators,
measuring a first frequency deviation ($\Delta$Nm) between the frequencies of the two oscillators subjected to the minimum control value,
applying a maximum control value (SM, SC1) to each of the two oscillators,
measuring a second frequency deviation ($\Delta$NM) between the frequencies of the two oscillators subjected to the maximum control value,
determining a slope deviation ($\Delta$p) between response curves of the first and second oscillators (OSC1, OSC2) depending on a difference (SR) between the first and second deviations and on a difference between the minimum and maximum control values, the slope deviation being used to determine by interpolation the corrected frequency measurement (N2C).

4. The method according to one of claims 1 to 3, wherein the corrected frequency measurement (N2C) is determined depending on a frequency deviation ($\Delta$Nm) measured between the first and second oscillators (OSC1, OSC2) subjected to a minimum control value (Sm), and on the minimum control value.

5. The method according to one of claims 1 to 3, wherein the third control value (SC1) is such that the measured frequency of the first oscillator (OSC1) subjected to the third control value, corresponds to the desired frequency (NC1).

6. The method according to claim 5, comprising a calibration phase comprising steps of:

determining the third control value (SC1), and
measuring the frequency (NC2) of the second oscillator (OSC2) subjected to the third control value.

7. The method according to one of claims 1 to 6, wherein each frequency measurement of one or other of the two oscillators (OSC1, OSC2) comprises a step of counting a number of cycles (N1, N2) of the oscillator during a period of a synchronization signal (SNC).

8. The method according to claim 7, wherein the synchronization signal (SNC) is supplied by a communication interface (ICT).

9. The method according to claim 8, comprising a step of supplying a signal at the frequency of the first oscillator (OSC1), at the output of the first oscillator, as clock signal of a device (DV) conforming to the USB 2.0 standard, the frequency (F1) of the first oscillator being equal to 6MHz with an error margin of $\pm$ 90KHz, or to 48MHz with an error margin of $\pm$ 120KHz.

10. The method according to one of claims 1 to 9, wherein the determination of the new first control value (S1') comprises steps of:

determining a first difference ($\Delta$Nr) between the measured frequencies (N1, N2) of the first and second oscillators (OSC1, OSC2),
determining a second difference ($\Delta$Nx) between the desired frequency (NC) and the measured frequency (N1) of one of the first and second oscillators (OSC1, OSC2),
dividing the first difference by a difference ($\Delta$S) in control values (S1, S2) applied to the first and second oscillators, to obtain a frequency pitch ($\Delta$FS),
dividing the second difference by the frequency pitch to obtain a correction value (CR1), and

adding the correction value to the first control value (S1) to obtain the new control value.

11. The method according to claim 10, wherein the difference in control values ($\Delta$S) is set, a new second control value (S2') is determined depending on the new first control value (S1') or on the correction value (CR1) to keep the difference in control values.

12. A frequency adjusting circuit for adjusting the frequency of an oscillator to a desired frequency, comprising first and second oscillators (OSC1, OSC2) each having a frequency (F1, F2) adjustable by a control value (S1, S2), the frequency adjusting circuit being configured to implement the method according to one of claims 1 to 11.

13. The circuit according to claim 12, wherein each of the first and second oscillators (OSC1, OSC2) comprises a ring oscillator (OSC) comprising delay circuits (DL1-DLn) that can be activated separately according to the control value (S1, S2) applied to the oscillator.

14. A USB 2.0 device comprising:

an interface circuit (ICT) receiving a data signal (DS) conforming to the USB 2.0 standard, and
a frequency adjusting circuit (CFC, CFC2) according to one of claims 12 and 13.

15. The device according to claim 14, wherein the interface circuit (ICT) supplies the frequency adjusting circuit (CFC, CFC2) with the synchronization signal (SNC).

Fig. 1

Fig. 2

Fig. 3

Fig. 4

OSC1, OSC2

Fig. 5

Fig. 6

Fig. 7

Fig. 8

Fig. 9

Fig. 10

Fig. 11

ST1 — SC / OSC1 → N1C

ST2 — SC1 → MEM

ST4

ST3 — SC1>SR/2? —Y→ ΔS = −ΔS

↓N

ST5 — SC1 → OSC2

ST6 — OSC2 → N2C

ST7 — ΔNC = N1C − N2C → MEM

ST8 — Sm → OSC2
Sm → OSC1

ST9 — OSC1 → N1m
OSC2 → N2m

ST10 — ΔNm = N1m − N2m → MEM

S11 — SM → OSC2
SM → OSC1

ST12 — OSC1 → N1M
OSC2 → N2M

ST13 — ΔNM = N1M − N2M

ST14 — Δp = (ΔNM − ΔNm)/(SM − Sm) → MEM

Fig. 12

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- FR 2978258
- US 20130021106 A